# EUROPÄISCHE PATENTANMELDUNG

(11) **EP 4 575 439 A1**
(43) Veröffentlichungstag der Anmeldung: **25.06.2025**
(21) Anmeldenummer: 24221374.2
(22) Anmeldetag: 19.12.2024
(51) Int. Cl.: G01L 1/16

(54) **SENSORVORRICHTUNG MIT OBERFLÄCHENWELLENRESONATOR**

(30) Priorität: 20.12.2023 DE 102023135982; 20.12.2023 DE 102023136018; 13.02.2024 DE 102024000457
(71) Anmelder: WIKA Alexander Wiegand SE & Co. KG, 63911 Klingenberg/Main (DE)
(72) Erfinder: PFEIFER, Fabian, 63820 Elsenfeld (DE)
(74) Vertreter: Liedtke & Partner Patentanwälte

(57) **Zusammenfassung**

Die vorliegende Erfindung betrifft eine Sensorvorrichtung (100) mit einem metallischen Trägersubstrat (200) und einem Oberflächenwellenresonator (300) mit einem Chipkörper (310). In eine Oberseite (313) des Chipkörpers (310) ist eine Resonatorstruktur (320) eingebettet oder auf diese aufgetragen. Der Oberflächenwellenresonator (300) ist mittels einer Glasschicht (400) auf dem Trägersubstrat (200) befestigt.

## Beschreibung

### TECHNISCHES GEBIET

### Die Erfindung betrifft eine Sensorvorrichtung mit einem passiven

Oberflächenwellenresonator (im Englischen "surface acoustic wave resonator", im Folgenden daher abgekürzt als SAW-Resonator bezeichnet), welche insbesondere zur Messung von mechanischen Spannungen beziehungsweise zur Dehnungsmessung an einem Verformungskörper eingerichtet ist.

Passive akustische Oberflächenwellensensoren (SAW-Resonatoren) werden allgemein für die drahtlose Überwachung physikalischer Bedingungen eingesetzt, insbesondere in rauen Umgebungen. Die Grenzen bei der Anwendung zur Dehnungsmessung ergeben sich jedoch in der Regel aus dem Design der funktionalen Zwischenschicht, die den SAW-Resonator mit einer Oberfläche des Verformungskörpers verbindet.

Bei Anwendungen der mechanischen Dehnungsmessung, wie z.B. der Drehmoment- oder Kraftmessung, werden die SAW-Resonatoren in der Regel mit Hilfe von Zwischenschichten auf eine Oberfläche des Verformungskörpers geklebt oder direkt auf den Verformungskörper aufgebracht. Im Folgenden wird die Oberfläche des Verformungskörpers auch als Trägersubstrat bezeichnet, während eine gegebenenfalls vorhandene Zwischenschicht als SAW-Resonatorsubstrat, SAW-Wafersubstrat oder als Chipkörper bezeichnet wird.

Die direkte Integration von SAW-Resonatoren auf der Oberfläche eines metallischen Verformungsträgers stellt hohe Anforderungen an die Abscheidung der piezoelektrischen Schicht. Im Vergleich zur Herstellung auf konventionellen SAW-Wafersubstraten weisen diese Bauelemente deutlich geringere Qualitätsfaktoren und schlechtere Signaleigenschaften auf, außerdem ist der Produktionsaufwand pro Sensor wesentlich höher. Außerdem ist die piezoelektrische Schicht bei hohen Belastungen anfällig für Risse.

Ähnlich wie bei der Montage von Dehnungssensoren auf Polymerfolienbasis wird auch bei der Montage von SAW-Resonatoren auf Trägersubstraten die bewährte Klebeverbindung angewendet. Die Verwendung von Hochleistungsklebstoffen zeigt die Fähigkeit dieser Verbindungstechnologie, hohe Dehnungsübertragungsverhältnisse zu erreichen. Im Vergleich zu elastischen Dehnungssensoren auf Polymerfolienbasis sind die Steifigkeiten von piezoelektrischen SAW-Resonatoren deutlich höher. Trotz optimierter Designs der Klebeverbindung führt dies zu zeit- und temperaturabhängigen Effekten. Insbesondere im Bereich der Glasübergangstemperatur des Klebstoffes kommt es zu signifikanten Veränderungen der Dehnungsübertragungseigenschaften bis hin zur irreversiblen Verstimmung des SAW-Resonators.

Ansätze zum Verschmelzen einer aufgebrachten Rückseitenmetallisierung von SAW-Sensoren mit metallischen Trägersubstraten unter Verwendung hochreaktiver Nanofilme führen zu starken lokal eingebrachten thermischen Spannungen aufgrund von Temperaturgradienten innerhalb des SAW-Resonators. Außerdem führen die hohen Temperaturen, die zum Schmelzen der metallischen Grenzflächen erforderlich sind, zu einer Beschädigung der Kristallstruktur des SAW-Resonatorsubstrates.

Daher wird ein alternatives Anbindungsverfahren - im Folgenden auch als Bondverfahren bezeichnet - benötigt, um SAW-Resonatoren für erweiterte Betriebstemperaturbereiche und hohe Dehnungsübertragungsraten unter rauen Umweltbedingungen auf metallischen Verformungskörpern zu befestigen.

### AUFGABE DER ERFINDUNG

Es ist die Aufgabe der Erfindung, eine neuartige Sensorvorrichtung mit einem Oberflächenwellenresonator anzugeben.

Diese Aufgabe wird gelöst durch eine Sensorvorrichtung, welche die in Anspruch 1 angegebenen Merkmale aufweist.

Vorteilhafte Ausgestaltungen der Erfindung sind Gegenstand der abhängigen Ansprüche.

### ZUSAMMENFASSUNG DER ERFINDUNG

Gemäß der vorliegenden Erfindung umfasst eine Sensorvorrichtung ein metallisches Trägersubstrat und einen Oberflächenwellenresonator.

Das metallische Trägersubstrat ist dabei beispielsweise Teil eines Verformungskörpers, der mechanischen Belastungen oder Kräften ausgesetzt ist und sich infolge dieser mechanischen Belastungen und Kräfte verformt. Mit Hilfe des Oberflächenwellenresonators, welcher auch als Sensorelement bezeichnet werden kann, soll die Verformung des Verformungskörpers detektierbar gemacht werden. Insbesondere ist das Trägersubstrat, also zumindest auch abschnittsweise der Verformungskörper, aus einem Edelstahl gebildet. Dadurch kann der Verformungskörper in einer Vielzahl von Applikationen eingesetzt werden. Zum Beispiel kann der Verformungskörper als Druckmesskapsel oder als Kraftaufnehmer ausgebildet sein.

Der Oberflächenwellenresonator umfasst einen Chipkörper. Weiterhin ist eine Resonatorstruktur in eine Oberseite des Chipkörpers eingebettet oder auf der Oberseite aufgetragen.

Beispielsweise kann die Resonatorstruktur einen sogenannten Eintor-Resonator umfassen, welcher einen Sende-Empfangs-Interdigitalwandler zwischen zwei nahezu vollständig reflektierenden Elektrodengittern, welche einen Resonanzraum bilden, aufweist. Die auslaufenden und reflektierten Wellen zwischen dem Interdigitalwandler und den Reflektorgittern interferieren zu einer stehenden Welle. Das so erzeugte Wellenfeld ist als Folge der Mehrfachreflektion äußerst schmalbandig.

Der Oberflächenwellenresonator ist mittels einer Glasschicht auf dem Trägersubstrat befestigt. Dabei kann es sich insbesondere um eine bleifreie Glasschicht handeln, da bleihaltige Gläser aufgrund eines gesteigerten marktseitigen und normativen Umweltbewusstseins zunehmend zu vermeiden sind. Im Kontext der Verwendung von Glas als Verbindungsmittel kann das Glas auch als Glaslot oder Lotglas bezeichnet werden. Glasschichten können beispielsweise durch ein Auftragen einer Glasfritte oder Glaspaste auf dem Trägersubstrat und ein anschließendes Aufschmelzen der Glasfritte bzw. -paste erzeugt werden.

Durch die Verwendung eines Glases zur Anbindung des Oberflächenwellenresonators an das Trägersubstrat, anstelle der aus dem Stand der Technik bekannten Verwendung eines Klebstoffes, kann die Sensorvorrichtung deutlich vielseitiger und unter deutlich anspruchsvolleren Umgebungsbedingungen eingesetzt werden. So sind Glaslote im Allgemeinen unempfindlich gegenüber Feuchtigkeit und - insofern die Umgebungstemperatur unterhalb der Glasübergangstemperatur liegt - weisen über einen weiten Temperaturbereich näherungsweise temperaturunabhängige Materialeigenschaften auf. Dies gilt insbesondere für ihren Speichermodul sowie für ihren thermischen Expansionskoeffizienten (im Englischen "coefficient of thermal expansion", CTE). Weiterhin zeigen Gläser ein deutlich schwächeres viskoelastisches Verhalten im Vergleich zu Klebstoffen. Somit kann über einen weiteren Temperaturbereich eine konstant hohe und von der Belastungsdauer unabhängige Übertragung mechanischer Spannungen vom Trägersubstrat auf den Oberflächenwellenresonator erzielt werden, und damit eine verbesserte Messgenauigkeit.

In einer exemplarischen Ausgestaltung der Sensorvorrichtung ist die Glasschicht zumindest abschnittsweise zwischen einer der Oberseite gegenüberliegenden Unterseite des Chipkörpers und dem Trägersubstrat angeordnet. Dabei weist die Glasschicht einen Außenrand auf, welcher zwischen der Oberseite und der Unterseite des Chipkörpers ausgebildete Randseiten umrahmt. Dabei grenzt der Außenrand der Glasschicht einen definierten Oberflächenabschnitt des Trägersubstrats ein, welcher von der Glasschicht bedeckt ist; die Glasschicht haftet insbesondere auf der gesamten Fläche dieses Oberflächenabschnitts auf dem Trägersubstrat und es liegen keine Gas- oder Lufteinschlüsse vor. Der Randbereich des Chipkörpers ist von dem Außenrand der Glasschicht umschlossen, was bedeutet, dass der Chipkörper entlang seiner gesamten durch die Grundform definierten Bodenfläche durch das Glaslot auf dem Trägersubstrat befestigt ist und an keiner Stelle, also auch an keiner Ecke, über den Außenrand der Glasschicht hinausragt. Stattdessen überragt der Außenrand der Glasschicht die Grundform des Chipkörpers vollumfänglich, was bedeutet, dass es an jeder Stelle in einer Draufsicht einen nicht-verschwindenden Abstand zwischen dem Außenrand und dem Chipkörper gibt. Insbesondere existieren keine Gas- oder Lufteinschlüsse zwischen der Glasschicht und dem Chipkörper. Durch diese exemplarische Ausgestaltung kann eine besonders gleichmäßige Übertragung mechanischer Spannungen vom Trägersubstrat auf den Oberflächenwellenresonator erzielt werden. Außerdem ist die Anbindung des Oberflächenwellenresonators hinsichtlich ihrer Haftfestigkeit auf dem Trägersubstrat in dieser Ausgestaltung besonders stabil. Dass die Glasschicht in dieser Ausgestaltung "zumindest abschnittsweise" zwischen der Unterseite des Chipkörpers und dem Trägersubstrat angeordnet ist, bedeutet, dass ein Abschnitt der Glasschicht eben genau dort liegt. Jedoch können sich andere Abschnitte der Glasschicht, insbesondere solche, welche in einer Draufsicht über den Chipkörper lateral hinausragen, durchaus auch in Bereiche oberhalb der Unterseite erstrecken. Dabei kann die Glasschicht insbesondere die zwischen der Oberseite und der Unterseite des Chipkörpers ausgebildeten Randseiten des Chipkörpers teilweise oder sogar vollständig bedecken, sodass nur die Oberseite des Chipkörpers vollständig aus der Glasschicht herausragt oder zumindest nicht durch die Glasschicht bedeckt ist, wie im Folgenden anhand einer weiteren exemplarischen Ausgestaltung noch näher erläutert.

In einer exemplarischen Weiterbildung dieser Ausgestaltung kann der Chipkörper eine Grundform aufweisen und die Glasschicht eine Basisform aufweisen, welche symmetrisch zur Grundform des Chipkörpers ist. Die Basisform ist jedoch gegenüber der Grundform größer skaliert, sodass der Chipkörper zuverlässig von der Glasschicht umrahmt werden kann, wie in der vorausgegangenen exemplarischen Ausgestaltung erläutert. Der Chipkörper ist zentriert und symmetrisch innerhalb der Glasschicht positioniert. Somit liegen insbesondere auch die Schwerpunkte und Symmetrieachsen der Basisform und der Grundform übereinander und die Basisform ragt zu allen Seiten zumindest im Wesentlichen gleich weit über die Grundform hinaus. Das heißt, ein Abstand zwischen einem äußeren Rand der Basisform und einem äußeren Rand der Grundform ist zumindest im Wesentlichen konstant.

In einer exemplarischen Ausgestaltung der Sensorvorrichtung sind der Chipkörper, das heißt dessen Grundform, und die Basisform der Glasschicht vieleckig ausgebildet. Insbesondere weist der Chipkörper dabei eine Höhe und eine definierte Grundform senkrecht zu seiner Höhe auf. Die Grundform ist beispielsweise festgelegt durch eine gerade Anzahl von mindestens vier Ecken sowie durch eine entsprechende Anzahl von jeweils zwischen zwei benachbarten Ecken ausgebildeten geraden Seitenkanten. Zudem weist die Grundform beispielsweise mindestens zwei Symmetrieachsen auf. Somit kann die Grundform des Chipkörpers beispielsweise einem Rechteck oder einem Quadrat entsprechen. Abweichend hierzu können die Grundform und die Basisform jeweils auch eine andere Anzahl an Ecken aufweisen. Auch ist es möglich, dass die Grundform und die Basisform nicht eckig, beispielsweise rund oder oval oder als Freiform ausgebildet sind. Bei einer eckigen Ausbildung ist zwischen jeweils zwei benachbarten Ecken jeweils eine Seitenkante ausgebildet, wobei eine Anzahl der Ecken der Basisform mit jener der Grundform übereinstimmt. Aufgrund der Oberflächenspannung und Viskosität typischer Glaslote, insbesondere bei niedrig schmelzenden Lotgläsern (welche in dieser Anwendung besonders vorteilhaft sein können, wie im Kontext einer exemplarischen Ausgestaltung im Folgenden erläutert), sind keine beliebig scharfen Ecken oder vollständig gerade Kantenbereiche realisierbar. Stattdessen verläuft der Außenrand der Glasschicht ausnahmslos stetig, ohne Sprünge oder Knickpunkte. Im Sinne dieser Ausgestaltung entsprechen "Ecken" der Basisform daher insbesondere Rundungen mit mehr oder weniger kleinem Radius und die Seitenkanten der Basisform können von einem geraden Verlauf abweichen, Rundungen, Aus- und Einbuchtungen aufweisen, ohne von der Lehre dieser exemplarischen Ausgestaltung abzuweichen. Seiten- und Längenverhältnisse der Basisform gleichen jenen der Grundform bei gleichen Symmetrieachsen, zumindest im Rahmen der technisch bei der Applikation einer Glasfritte oder Glaspaste sowie während des Aufschmelzens der Glasfritte oder -paste, erzielbaren Genauigkeit.

In einer exemplarischen Ausgestaltung der Sensorvorrichtung weist der Außenrand der Glasschicht an jeder der Ecken der Basisform eine nach außen gerichtete Ausbuchtung auf. Dadurch kann vorteilhaft erreicht werden, dass sich in der Mitte der Glasschicht ein Plateaubereich ausbildet, welcher auch in den Bereichen der Ecken der Basisform nicht zu stark abfällt. In diesem Plateaubereich kann der Chipkörper zuverlässig über seine gesamte Bodenfläche und seine Seitenflächen angebunden werden, insbesondere, wenn der Chipkörper dabei in der Glasschicht teilweise eingesunken platziert werden soll.

In einer exemplarischen Ausgestaltung der Sensorvorrichtung kann der Außenrand der Glasschicht wenigstens an einer Stelle zwischen zwei aufeinanderfolgenden Ecken der Basisform zumindest abschnittsweise höchstens um eine erste Länge von einer nächstgelegenen Seitenkante des Chipkörpers beabstandet sein. Zugleich kann der Außenrand an wenigstens einer der Ausbuchtungen zumindest abschnittsweise mindestens um eine zweite Länge von einer nächstgelegenen Ecke des Chipkörpers beabstandet sein, wobei die zweite Länge um mindestens 10% größer ist als die erste Länge. Insbesondere ist die zweite Länge sogar um mindestens 50% größer, insbesondere um mindestens 100% größer als die erste Länge. Dass die vorstehend genannten Beabstandungen an "wenigstens einer Stelle zwischen aufeinanderfolgenden Ecken der Basisform", respektive "an wenigstens einer der Ausbuchtungen" vorliegen sollen, bedeutet, dass - unter Einhaltung der im Vorangehenden eingeführten Symmetrien - nicht an allen Stellen zwischen allen möglichen Paaren von zwei aufeinanderfolgenden Ecken der Basisform, respektive nicht an allen Ausbuchtungen, die gleichen Abstände eingehalten werden müssen.

In einer exemplarischen Ausgestaltung der Sensorvorrichtung weist der Außenrand jedoch jeweils zwischen jedem Paar von zwei benachbarten Ausbuchtungen eine Stelle auf, an welcher er zumindest abschnittsweise von der nächstgelegenen Seitenkante des Chipkörpers höchstens um die erste Länge beabstandet ist. Zugleich ist der Außenrand in dieser Ausgestaltung an jeder der Ausbuchtungen zumindest abschnittsweise von der jeweils nächstgelegenen Ecke des Chipkörpers um mindestens die zweite Länge beabstandet. "Zumindest abschnittsweise" bedeutet im Kontext dieses Beispiels, sowie auch in allen folgenden Abschnitten mit ähnlichem Kontext, dass an wenigstens einem Punkt entlang des Außenrandes das jeweilige Merkmal - also der jeweilige Mindest- oder Höchstabstand - erfüllt ist. Insbesondere werden die jeweiligen Merkmale jedoch nicht nur an einem Punkt, sondern entlang eines zusammenhängenden Segments des Außenrandes eingehalten. Durch die in dieser Ausgestaltung gegebenen Höchst- beziehungsweise Mindestabstände können die Merkmale und Vorteile der vorangehend genannten exemplarischen Ausgestaltung besonders effizient realisiert werden. So wird durch die abschnittsweise Einhaltung eines maximalen Abstands von höchstens der ersten Länge in Bereichen zwischen zwei Ausbuchtungen die Gesamtgröße des mit der Glasschicht bedeckten Oberflächenabschnitts begrenzt und damit auch die Gesamtmenge der zur Herstellung dieser Oberflächenbedeckung nötigen Glasfritte oder Glaslotmenge. Gleichzeitig sorgt die zumindest abschnittsweise Einhaltung eines Mindestabstands von wenigstens der zweiten Länge an den Ausbuchtungen dafür, dass sich in der Mitte der Glasschicht ein Plateaubereich ausbildet, innerhalb dessen der Chipkörper zuverlässig, stabil und präzise platziert werden kann.

Weiterhin kann exemplarisch die Basisform der Glasschicht die Grundform vollumfänglich um das 3- bis 7-fache, insbesondere um das 4- bis 6-fache, insbesondere genau um das 5-fache einer Höhe des Chipkörpers lateral überragen beziehungsweise über die Grundform hinausragen. Das bedeutet, der Außenrand ist stets mindestens um diese Distanz von der nächstgelegenen Ecke oder Seitenkante des Chipkörpers entfernt; durch diese in Vielfachen der Höhe des Chipkörpers angegebene Distanz ist somit ein Mindestabstand zwischen Außenrand und Chipkörper definiert. In diesem Parameterbereich kann ein Kraftfluss beziehungsweise eine Übertragung mechanischer Spannungen vom Trägersubstrat zum Oberflächenwellenresonator besonders effektiv und unter optimiertem Materialaufwand realisiert werden. In Verbindung mit der unmittelbar vorangehend genannten Ausgestaltung kann dabei vorgesehen sein, dass die erste Länge dem in diesem Beispiel genannten Vielfachen der Höhe des Chipkörpers genau entspricht oder nur geringfügig größer gewählt ist, also beispielsweise um 5-10 Prozent größer. Dadurch können die Vorteile beider exemplarischer Ausgestaltungen kombiniert werden.

In einer weiteren exemplarischen Weiterbildung der zuvor genannten Ausgestaltung kann - ungeachtet einer konkreten Basisform der Glasschicht - vorgesehen sein, dass der Außenrand zumindest abschnittsweise in einem Bereich entlang mindestens einer Seitenkante des Chipkörpers von diesem höchstens um eine erste Länge beabstandet ist und zumindest abschnittsweise in einem Bereich an mindestens einer Ecke des Chipkörpers von dieser mindestens um eine zweiten Länge beabstandet ist, wobei die zweite Länge um mindestens 10% größer ist, insbesondere um mindestens 50% größer ist, insbesondere um mindestens 100% größer ist als die erste Länge. Die erste Länge beziehungsweise die zweite Länge aus diesem Beispiel kann dabei als entsprechend zu der in einem vorangegangenen Beispiel eingeführten ersten Länge respektive zweiten Länge verstanden werden. Ausführungen zu Begrifflichkeiten wie "wenigstens einer" und "zumindest abschnittsweise" aus vorangegangenen Abschnitten sind analog auf dieses Beispiel anwendbar. Ebenso können mit den Merkmalen aus diesem Beispiel die gleichen Vorteile erzielt werden, die in dem vorangegangenen Abschnitt mit Bezug auf die erste und zweite Länge erläutert wurden. Dieses Beispiel ist im Gegensatz zu dem vorangegangenen Beispiel lediglich nicht darauf eingeschränkt, dass die Glasschicht eine erkennbare Basisform mit Ausbuchtungen aufweisen muss.

Auch hierbei kann der Chipkörper eine Grundform aufweisen, welche durch die Seitenkanten sowie durch eine gerade Anzahl von mindestens vier Ecken gebildet ist, wobei die Grundform beispielsweise mindestens zwei Symmetrieachsen aufweist. Jedoch sind auch hier wieder abweichende eckige Ausbildungen der Grundform möglich.

Weiterhin kann in dieser Weiterbildung vorgesehen sein, dass der Außenrand an einem jeden Punkt mindestens um das 3- bis 7-fache, insbesondere um das 4- bis 6-fache, insbesondere um das 5-fache der Höhe des Chipkörpers von einer jeweils nächstgelegenen Seitenkante oder Ecke des Chipkörpers beabstandet ist. Durch diese beispielhafte Ausgestaltung wird somit ein Mindestabstand zwischen Außenrand und Chipkörper definiert. In diesem Parameterbereich kann ein Kraftfluss beziehungsweise eine Übertragung mechanischer Spannungen vom Trägersubstrat zum Oberflächenwellenresonator besonders effektiv und unter optimiertem Materialaufwand realisiert werden. In Verbindung mit dem vorangehend genannten Merkmalen dieser Weiterbildung kann dabei vorgesehen sein, dass die erste Länge dem in diesem Beispiel genannten Vielfachen der Höhe des Chipkörpers genau entspricht oder nur geringfügig größer gewählt ist, also beispielsweise um 5-10 Prozent größer. Dadurch können die Vorteile beider exemplarischer Weiterbildungen kombiniert werden.

In einer weiteren exemplarischen Ausgestaltung der Sensorvorrichtung schließt sich eine Oberfläche der Glasschicht zumindest entlang eines Randabschnitts des Chipkörpers zumindest im Wesentlichen bündig an die Oberseite des Chipkörpers an. Der Randabschnitt kann dabei zumindest abschnittsweise Randflächen des Chipkörpers, insbesondere eine oder mehrere Seitenkanten des Chipkörpers und/oder eine oder mehrere Ecken des Chipkörpers, umfassen. "Im Wesentlichen bündig" bedeutet in diesem Kontext, dass die Glasschicht keinen Teil der Oberseite des Chipkörpers bedeckt, also sich nicht über eine Seitenkante auf die Oberseite des Chipkörpers hinaus erstreckt. Ebenso bedeutet es, dass zwischen der Oberfläche der Glasschicht und der Oberseite des Chipkörpers auch keine sprungartige Stufe verbleibt. Die Oberfläche der Glasschicht endet also genau an dem Randabschnitt, welcher die Oberseite des Chipkörpers begrenzt. Insbesondere geht die Oberfläche der Glasschicht an dem Randabschnitt dabei stetig in die Oberseite des Chipkörpers über. Ein Sprung in der Steigung, also ein Knick im Verlauf beim Übergang von der Glasschicht zur Oberseite, soll im Kontext dieser Ausgestaltung aber ebenfalls als im Wesentlichen bündig verstanden werden. Durch diese Ausgestaltung kann ein besonders effektiver Kraftfluss beziehungsweise eine besonders effektive Übertragung mechanischer Spannungen zwischen Trägersubstrat und Oberflächenwellenresonator erzielt werden. Insbesondere können Kräfte beziehungsweise mechanische Spannungen direkt bis in die oberste Schicht des Chipkörpers übertragen werden, in welcher sich die Oberflächenwellen innerhalb der Resonatorstruktur bewegen. Gleichzeitig wird durch den im Wesentlichen bündigen Abschluss eine Beeinträchtigung der Funktion des Oberflächenwellenresonators effektiv verhindert. Es zeigt sich nämlich, dass Oberflächenwellen, welche im Chipkörper an dessen Oberseite angeregt werden, stark gestört werden, wenn auch nur geringe Mengen Glas sich über einen Randabschnitt auf die Oberseite des Chipkörpers erstrecken. Außerdem könnten solche Glasschichtteile, die sich stellenweise über die Oberseite des Chipkörpers erstrecken, bei Temperaturänderungen zu Verspannungen in der Oberseite führen, welche ebenfalls das Wellenfeld oder die Messeigenschaften des Oberflächenwellenresonators stark stören würden. Weiterhin kann durch den bündigen Anschluss der Glasschicht an den Randabschnitt erzielt werden, dass Mikrorisse und mikroskopische Kantenabbrüche oder -ausbrüche am Chipkörper, welche grundsätzlich während des Herstellungsprozesses des Chipkörpers verfahrensbedingt entstehen können, durch Benetzung mit dem Lotglas infolge der geometrischen Merkmale dieser Ausgestaltung ausgeheilt werden. Das bedeutet, das Glas kann während der Anbindung des Chipkörpers auf dem Trägersubstrat in diese Risse und Ausbrüche einfließen und sie ausfüllen. Dadurch können die Messeigenschaften des Oberflächenwellenresonators verbessert und seine Empfindlichkeit gegenüber Umgebungseinflüssen reduziert werden und die mechanische Stabilität der Sensorvorrichtung sowie ihre Ausfallsicherheit unter Langzeit- sowie Wechselbelastung kann verbessert werden. Entsprechend kann in einem Beispiel vorteilhaft vorgesehen sein, dass sich die Oberfläche der Glasschicht entlang aller Seitenkanten und Ecken des Chipkörpers im Wesentlichen bündig an diesen anschließt, sodass sich die Oberfläche der Glasschicht also an keinem Randabschnitt des Chipkörpers nicht bündig an die Oberseite anschließt.

In einer weiteren exemplarischen Ausgestaltung der Sensorvorrichtung sind die Ecken der Grundform des Chipkörpers abgerundet ausgebildet. Eine derartige Eckenform kann beispielsweise durch Ätzverfahren erzielt werden. Durch diese Ausgestaltung kann eine Anbindung des Chipkörpers an die Glasschicht verbessert werden. Insbesondere kann ein vollumfängliches, zumindest im Wesentlichen bündiges Anschließen der Oberfläche der Glasschicht an die Oberseite des Chipkörpers, wie in der vorangegangenen exemplarischen Ausgestaltung vorgeschlagen, in dieser Ausgestaltung erleichtert werden.

In einer weiteren exemplarischen Ausgestaltung steigt die Oberfläche der Glasschicht zumindest entlang eines Randabschnitts des Chipkörpers in ihrem Verlauf von diesem weg, bis zu ihrem Außenrand hin, zunächst zu einem höchsten Punkt an, welcher höher liegt als die Oberseite des Chipkörpers. In Abhängigkeit von Oberflächenspannung, Viskosität und dem Winkel, unter welchem sich die Oberfläche der Glasschicht an den Randabschnitt des Chipkörpers anschließt, kann die Oberfläche dabei eine Änderung ihrer Wölbung von zunächst konkav zu konvex erfahren; die Oberfläche kann aber auch über ihren gesamten Verlauf vom Randabschnitt bis zum Außenrand konvex verlaufen. Nach Erreichen des höchsten Punktes fällt sie jedenfalls ohne Ausbildung eines makroskopischen konkav geformten Abschnitts stetig zum Außenrand hin ab. Die Wölbung bleibt also über den weiteren Verlauf konvex, die Krümmung kann zum Rand hin jedoch abnehmen. In einem Querschnitt betrachtet, welcher beispielsweise senkrecht zur Oberfläche des Trägersubstrats und zum Randabschnitt verläuft, folgt die Oberfläche der Glasschicht somit einer Kurve, welche in Richtung vom Randabschnitt des Chipkörpers weg, hin zum Außenrand der Glasschicht zunächst höchstens einen Wendepunkt, anschließend einen Scheitelpunkt und danach keine weiteren Wende-, Terrassen- oder Scheitelpunkte aufweist. Dem Vorgenannten soll es nicht entgegenstehen, dass die Glasschicht in Abhängigkeit von ihrer Oberflächenspannung, Viskosität sowie möglicher Mikrostrukturen der Oberfläche des Trägersubstrats direkt am Außenrand auf mikroskopischer Ebene gegebenenfalls einen konvexen Endabschnitt ausbildet. Der Randabschnitt, an welchem anschließend die Oberfläche der Glasschicht den gemäß dieser Ausgestaltung definierten Verlauf aufweist, kann dabei zumindest abschnittsweise eine oder mehrere Seitenkanten des Chipkörpers und/oder eine oder mehrere Ecken des Chipkörpers umfassen. Durch diese Ausgestaltung kann in vorteilhafter Weise erreicht werden, dass die effektive Querschnittsfläche des Teils der Glasschicht, welcher den Chipkörper umrahmt, vergrößert wird und dadurch mechanische Spannungsspitzen reduziert oder umgelenkt werden können. Dadurch kann die Stabilität der Sensorvorrichtung verbessert werden und es können stärkere Verformungen vom Trägersubstrat auf den Oberflächenwellenresonator übertragen werden, ohne die Glasschicht zu beschädigen. Dies bedeutet, dass die zulässige maximale Nenndehnung gesteigert wird. Außerdem kann durch die Ausbildung des Verlaufs mit einem höchsten Punkt, welcher höher liegt als die Oberseite des Chipkörpers, der Oberflächenwellenresonator teilweise vor Kontakt mit anderen Körpern geschützt werden, was insbesondere noch im Kontext einer folgenden Weiterbildung genauer erläutert wird.

Aufgrund der vorangehend genannten Vorteile kann entsprechend in einer exemplarischen Weiterbildung dieser Ausgestaltung vorgesehen sein, dass der Randabschnitt, entlang dessen die Oberfläche der Glasschicht von diesem weg, bis hin zu ihrem Außenrand den beschriebenen Verlauf nimmt, alle Seitenkanten und Ecken des Chipkörpers umfasst. Das heißt, die Glasschicht bildet einen ringwallartigen Kragen aus, welcher den Oberflächenwellenresonator vollumfänglich umrahmt. Dadurch können die vorangehend genannten Vorteile den Chipkörper vollständig umlaufend wirksam genutzt werden.

Der in dieser Ausgestaltung beschriebene höchste Punkt des Verlaufs der Oberfläche der Glasschicht kann exemplarisch um 10% bis 75%, insbesondere um 25% bis 50%, der Höhe des Chipkörpers höher liegen als die Oberseite des Chipkörpers. Dadurch können die vorteilhaften Wirkungen dieser Ausgestaltung besonders effektiv und unter optimiertem Materialaufwand erzielt werden. Auch wird durch die Begrenzung der Höhe des höchsten Punkts gemäß den hierin gegebenen Grenzen verhindert, dass eine Zugsteifigkeit der Sensorvorrichtung zu stark vergrößert und dadurch eine Sensitivität reduziert wird.

In einer weiteren exemplarischen Weiterbildung dieser Ausgestaltung kann die Sensorvorrichtung zudem eine Abdeckscheibe und einen Halterahmen umfassen. Der Halterahmen umrahmt den gesamten Oberflächenabschnitt, der mit der Glasschicht überzogen ist, und verbindet die Abdeckscheibe mit dem Trägersubstrat. Diese Verbindung ist dabei insbesondere hermetisch dicht. Oberflächenwellenresonatoren mit Abdeckscheiben vor Beeinträchtigungen - insbesondere vor Staub, Flüssigkeiten und sonstigen mechanischen Umgebungseinflüsse - zu schützen, ist im Stand der Technik bekannt. Jedoch konnte es bislang vorkommen, dass während der Montage von Abdeckscheibe und Halterahmen ein Oberflächenwellenresonator beschädigt wird, falls eines der genannten Teile auf die Oberseite des Chipkörpers fällt oder dagegen stößt. Durch die nach oben gerichtete Wölbung der Glasschicht, deren höchster Punkt höher liegt als die Oberseite des Chipkörpers, können solche Fehler vermieden werden, da die Glasschicht dann die Glasscheibe oder den Rahmen abfängt, bevor diese auf die empfindliche Oberseite des Oberflächenwellenresonators beziehungsweise Chipkörpers treffen können. Diese Schutzwirkung kann entsprechend besonders wirksam entfaltet werden, wenn die Glasschicht einen wallförmigen Kragen ausbildet, der den Chipkörper vollständig umschließt, wie in einer der vorangegangenen Weiterbildungen dargestellt.

In einer exemplarischen Ausführungsform der vorangegangenen Weiterbildung dieser Ausgestaltung ist der Halterahmen durch einen zusätzlichen Glaslotring oder einen zusätzlichen Rahmen aus Glaslot gebildet. Somit kann der Halterahmen mithilfe der gleichen oder ähnlichen Prozessschritte und -parameter hergestellt werden, wie schon die Anbindung zwischen Chipkörper und Trägersubstrat, wodurch die Herstellung der Sensorvorrichtung effizient gestaltet werden kann. Insbesondere wird für den Halterahmen ein Glaslot verwendet, welches eine niedrigere Schmelztemperatur als das zur Ausbildung der Glasschicht verwendete Glaslot aufweist. Dadurch kann der Halterahmen nach der Glasschicht hergestellt werden, ohne dass eine Prozesstemperatur so stark erhöht werden muss, dass die Glasschicht selbst wieder aufschmilzt.

Der Begriff "Randabschnitt" wird in der Beschreibung der vorangegangenen exemplarischen Ausgestaltungen einerseits zur Bezeichnung von Abschnitten benutzt, an welchen sich die Oberfläche der Glasschicht zumindest im Wesentlichen bündig an die Oberseite des Chipkörpers anschließt; andererseits wird der gleiche Begriff auch für solche Abschnitte verwendet, von welchen aus die Oberfläche der Glasschicht in ihrem Verlauf bis zum ihrem Außenrand hin zunächst zu einem höchsten Punkt ansteigt, welcher höher liegt als die Oberseite des Chipkörpers und anschließend ohne Ausbildung eines makroskopischen konkav geformten Abschnitts stetig zum Außenrand abfällt. Um Unklarheiten zu vermeiden, sei an dieser Stelle explizit gesagt, dass es sich in exemplarischen Ausgestaltungen der Sensorvorrichtung dabei sowohl um die gleichen Randabschnitte handeln kann - also bündiger Anschluss und entsprechender Verlauf zu einem höchsten Punkt am gleichen Randabschnitt kombiniert - als auch um unterschiedliche Randabschnitte handeln kann - also bündiger Anschluss nur an Abschnitten, von welchen aus die Oberfläche der Glasschicht bis zu ihrem Außenrand hin nicht den Anstieg zu einem höchsten Punkt nimmt. Ebenso können sich Randabschnitte mit dem einen Merkmal und Randabschnitte mit dem anderen Merkmal auch nur teilweise überlappen. Genauso können beide Ausprägungen gleichzeitig auch vollumfänglich zur Anwendung kommen, das heißt, entlang aller Seitenkanten und Ecken des Chipkörpers unterbrechungsfrei vorgesehen sein.

In einer weiteren exemplarischen Ausgestaltung der Sensorvorrichtung ist der Chipkörper aus einem anisotropen Material gebildet, welches in einer ersten Richtung einen ersten Wärmeausdehnungskoeffizienten und eine erste Dehnungssensitivität aufweist und in einer zweiten Richtung, welche orthogonal zur ersten Richtung liegt, einen zweiten Wärmeausdehnungskoeffizienten und eine zweite Dehnungssensitivität aufweist, die sich jeweils von dem ersten Wärmeausdehnungskoeffizienten beziehungsweise der ersten Dehnungssensitivität unterscheiden. Der Chipkörper ist dabei derart geformt und geschnitten, dass die erste und die zweite Richtung in einer Ebene parallel zur Oberseite des Chipkörpers liegen. Der zweite Wärmeausdehnungskoeffizient ist dabei niedriger als der erste Wärmeausdehnungskoeffizient. Ein Wärmeausdehnungskoeffizient des Trägersubstrats ist zudem kleiner als der erste Wärmeausdehnungskoeffizient und zugleich größer als der zweite Wärmeausdehnungskoeffizient gewählt. Dadurch kann erreicht werden, dass zwischen Chipkörper und Trägersubstrat Fehlanpassungen der Wärmeausdehnungskoeffizienten vorliegen, welche jedoch entlang der ersten und zweiten Richtung jeweils unterschiedliche Vorzeichen aufweisen. Das führt beispielsweise dazu, dass der Chipkörper bei einem Temperaturanstieg in der ersten Richtung eine relative Stauchung (das heißt, eine negative Dehnung oder Verringerung einer Streckung) erfährt, während er in der zweiten Richtung gleichzeitig eher eine relative Streckung (das heißt, eine positive Dehnung oder Verringerung einer Stauchung) erfährt. Da der Oberflächenwellenresonator mit einem Glaslot auf dem Trägersubstrat befestigt ist, erfährt er folglich im Ablauf des Bonding-Prozesses, während der Abkühlung und Erstarrung des Glaslotes, in der ersten Richtung eine Streckung, also positive Dehnung, und in der zweiten Richtung eine Stauchung, also negative Dehnung. Der Chipkörper ist also am Ende des Bonding-Prozesses aufgrund der festgelegten Fehlanpassungen der

Wärmeausdehnungskoeffizienten vorgespannt. Nun ist in dieser Ausgestaltung das Material des Chipkörpers so gewählt und ausgerichtet, dass die erste Dehnungssensitivität negativ und die zweite Dehnungssensitivität positiv ist. Eine negative Dehnungssensitivität bedeutet in diesem Kontext, dass die Resonanzfrequenz des Oberflächenwellenresonators mit zunehmender positiver Dehnung, also Streckung, abnimmt. Eine positive Dehnungssensitivität bedeutet entsprechend, dass die Resonanzfrequenz bei zunehmender positiver Dehnung, also Streckung, ansteigt. Bei Oberflächenwellenresonatoren kann die Dehnungssensitivität insbesondere als Änderungsrate der Resonanzfrequenz ausgedrückt werden, also ∂Δ*f*/∂*ε*, wobei Δ*f* die Differenz zwischen aktueller Resonanzfrequenz und einer Ausgangsfrequenz ist und *ε* die Dehnung. Somit führt die Vorspannung des Chipkörpers in beiden Richtungen jeweils zu einer Verringerung der Resonanzfrequenz. Das Material des Chipkörpers soll gleichzeitig jedoch ein Temperaturgang, also eine Temperaturabhängigkeit der Resonanzfrequenz aufweisen, welche bei dem Abkühlprozess in einer Erhöhung der Resonanzfrequenz resultiert. Entsprechend wirkt der Einfluss der fehlangepassten Wärmeausdehnungskoeffizienten in beiden Richtungen jeweils dem Temperaturgang des Chipkörpers entgegen und reduziert somit effektiv die thermische Quersensitivität des Oberflächenwellenresonators. Entsprechend kann mit einer Sensorvorrichtung gemäß dieser Ausgestaltung eine höhere Messgenauigkeit über weite Temperaturbereiche erzielt werden, wenn die Resonatorstruktur und damit die Wellenfeldrichtung (auch als Propagationsrichtung des Wellenfelds bezeichnet) parallel zur ersten oder zweiten Richtung verläuft.

Die Wirksamkeit dieser Vorspannung und Reduktion der thermischen Querempfindlichkeit kann gerade aufgrund der erfindungsgemäßen Anbindung mit einem Glaslot anstelle eines Klebstoffes über einen weiten Temperaturbereich genutzt werden. Klebstoffe weisen in der Regel stark temperaturabhängige Wärmeausdehnungskoeffizienten auf, während jene von Glasloten wesentlich temperaturunabhängiger sind.

In einer weiteren exemplarischen Ausgestaltung der Sensorvorrichtung weist der Oberflächenwellenresonator eine mittlere Resonanzfrequenz von 434 MHz oder 2,4 GHz auf und der Chipkörper weist eine Seitenlänge von mindestens 1,5 mm bis maximal 5 mm auf, insbesondere mindestens 2 mm bis maximal 3 mm. Durch die Verwendung der genannten Frequenzen kann ein kontaktloses Auslesen des Oberflächenwellenresonators in vielen Regionen lizenzfrei und häufig sogar genehmigungsfrei durchgeführt werden, da diese Frequenzen innerhalb der standardisierten ISM-Bänder liegen. Alternativ oder zusätzlich weist die Resonatorstruktur eine Länge von mindestens 1 mm, insbesondere von mindestens 1,5 mm, auf. Durch die Kombination dieser Parameter wird eine geringe Baugröße bei gleichzeitig hinreichend hoher Güte des Resonators erzielt, sodass die Sensorvorrichtung zuverlässig zur Ausführung einer Messaufgabe verwendet werden kann.

In einer weiteren exemplarischen Ausgestaltung der Sensorvorrichtung weist der Chipkörper eine Dicke von mindestens 20 µm bis maximal 100 µm, insbesondere von mindestens 25 µm bis maximal 60 µm, auf. Zugleich weist die Glasschicht in einem Flächenbereich direkt unterhalb des Chipkörpers eine Dicke von mindestens 10 µm bis maximal 200 µm, insbesondere von mindestens 12,5 µm bis maximal 120 µm, auf. Durch diese Maße kann eine stabile Anbindung zwischen Chipkörper und Trägersubstrat sowie eine zuverlässige Kraftübertragung vom Trägersubstrat auf den Chipkörper bei gleichzeitig optimiertem Materialbedarf erreicht werden.

In einer weiteren exemplarischen Ausgestaltung der Sensorvorrichtung ist der Chipkörper aus alpha-Quarz gebildet, wobei es sich um einen Y-35 ° X-Schnitt, einen Y-34 ° X-Schnitt oder einen Y-33 ° X-Schnitt handelt. Die Resonatorstruktur ist dabei derart ausgerichtet, dass sie sich entlang der x-Richtung erstreckt. Diese Materialwahl kann insbesondere zur Realisierung der im Vorangegangenen genannten Ausgestaltung, in welcher gezielt bestimmte thermische Vorspannungen im Chipkörper erzeugt werden, verwendet werden, da dadurch alle Anforderungen an den Chipkörper erfüllt sind und Glaslote verfügbar sind, welche die nötigen Bedingungen in Kombination mit diesem Chipkörpermaterial erfüllen. Unter einem Y-35 ° X-Schnitt wird dabei vorliegend ein Y-Schnitt verstanden, welcher jedoch um die X-Achse um 35 ° rotiert wurde. Ein nicht-rotierter Y-Schnitt ist ein Schnitt, der senkrecht zur Y-Achse verläuft. In der Notation gemäß ANSI/IEEE Std 176-1987 kann dieser Schnitt somit als YXwlt 0°/35°/0° angegeben werden.

In einer weiteren exemplarischen Ausgestaltung der Sensorvorrichtung ist die Glasschicht aus einem niedrig schmelzenden Glaslot gebildet, insbesondere aus einem Glaslot mit einer Schmelztemperatur unterhalb von 500 °C. Dadurch sind weniger hohe Temperaturen zum Schmelzen des Glaslots notwendig, sodass die Sensorvorrichtung kostengünstiger und mit geringerem Zeitaufwand hergestellt werden kann. Weiterhin können durch geringere Temperaturunterschiede während des Herstellungsprozesses thermische Vorspannungen insgesamt reduziert werden, was jedoch nicht als Widerspruch zu der vorangegangenen exemplarischen Ausgestaltung zu verstehen ist, in welcher gezielt gewisse thermische Vorspannungen eingestellt werden, um die thermische Quersensitivität des Oberflächenwellenresonators zu reduzieren. Durch diese Ausgestaltung kann erreicht werden, dass trotz des gegebenenfalls hohen Unterschieds zwischen der bei der Herstellung nötigen Schmelztemperatur und der zumeist deutlich niedrigeren Einsatztemperatur durch thermische Fehlanpassungen und Eigenspannungen keine derart hohen mechanischen Spannungen im Oberflächenwellenresonator hervorgerufen werden, die zu einer Beschädigung desselben führen können - unabhängig davon, ob thermische Fehlanpassungen zwischen dem Material des Chipkörpers, der Glasschicht und/oder dem Trägersubstrat beabsichtigt oder unbeabsichtigt vorliegen.

In einer weiteren exemplarischen Ausgestaltung der Sensorvorrichtung ist die Resonatorstruktur derart in oder auf der Oberseite des Chipkörpers ausgerichtet, dass eine Wellenfeldrichtung der Resonatorstruktur parallel zu einer der mindestens zwei Symmetrieachsen der Grundform des Chipkörpers verläuft. Insbesondere stehen wenigstens zwei Symmetrieachsen des Chipkörpers senkrecht aufeinander und die Resonatorstruktur ist um den Schnittpunkt dieser Symmetrieachsen zentriert, wobei die Wellenfeldrichtung parallel zu einer dieser beiden Symmetrieachsen verläuft. Durch diese Ausrichtung kann erzielt werden, dass Kräfte und Verformungen des Chipkörpers im Wesentlichen symmetrisch auf die Resonatorstruktur einwirken, wodurch die Messgenauigkeit verbessert sowie die Querempfindlichkeit reduziert werden kann. Besonders vorteilhaft kann diese Ausgestaltung mit der in einem vorangegangenen Abschnitt beschriebenen exemplarischen Ausgestaltung, bei welcher gezielt gewisse thermische Vorspannungen zur Reduzierung thermischer Querempfindlichkeit eingesetzt werden, kombiniert werden, wenn Symmetrieachsen des Chipkörpers sowie Kristallrichtungen mit entsprechenden Materialeigenschaften aufeinander abgestimmt werden. Dadurch lassen sich die Vorteile beider Ausgestaltungen miteinander verbinden.

Ausführungsbeispiele der vorliegenden Erfindung, sowie einige ihrer exemplarischen Ausgestaltungen, Ausführungsformen und Weiterbildungen, werden im Folgenden anhand von Zeichnungen näher erläutert.

### KURZBESCHREIBUNG DER ZEICHNUNGEN

Dabei zeigen:
- Figur 1: schematisch eine exemplarische Ausführung einer Sensorvorrichtung in einer Draufsicht,
- Figur 2: schematisch eine exemplarische Ausführung eines Oberflächenwellenresonators in einer perspektivischen Darstellung,
- Figur 3A, 3B, 3C, 3D: exemplarische Ausführungen eines Chipkörpers, jeweils schematisch in einer Draufsicht,
- Figur 4A, 4B, 4C, 4D: exemplarische Ausführungen der Sensorvorrichtung, jeweils schematisch in einer Draufsicht,
- Figur 5A: schematisch eine exemplarische Ausführung der Sensorvorrichtung in einer perspektivischen Ansicht,
- Figur 5B: schematisch einen Randbereich aus Figur 5A in einem Querschnitt,
- Figur 6A: schematisch eine exemplarische Ausführung der Sensorvorrichtung in einer perspektivischen Ansicht,
- Figur 6B: schematisch einen Randbereich aus Figur 6A in einem Querschnitt und
- Figur 7: schematisch eine exemplarische Ausführung der Sensorvorrichtung im Querschnitt.

Einander entsprechende Teile sind in allen Figuren mit identischen Bezugszeichen versehen.

### DETAILBESCHREIBUNG DER ZEICHNUNGEN

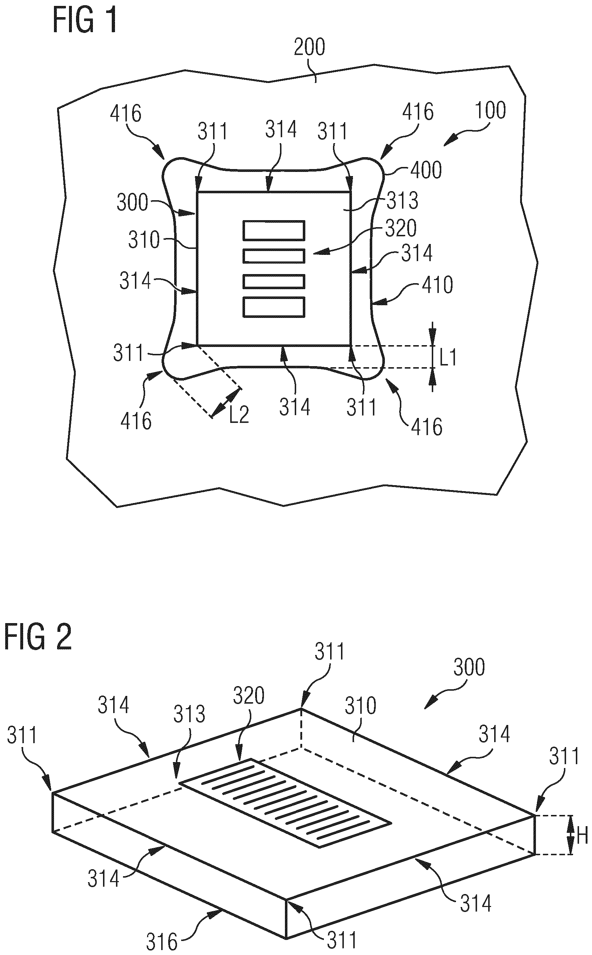

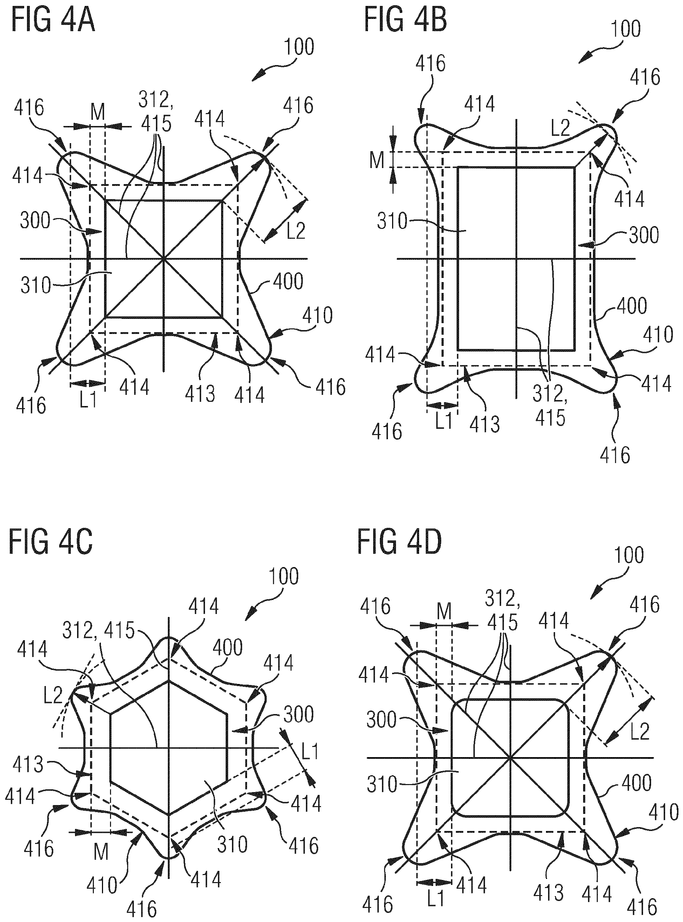

In Figur 1 ist eine exemplarische Ausführung einer Sensorvorrichtung 100 in einer Draufsicht dargestellt. Ein Oberflächenwellenresonator 300 ist mittels einer Glasschicht 400 auf einem Trägersubstrat 200 befestigt. Das Trägersubstrat 200 ist hierbei nur ausschnittsweise dargestellt und kann beispielsweise durch einen Oberflächenausschnitt eines Verformungskörpers, wie etwa einer Druckmesskapsel, einer Druckmessmembran oder eines Kraftaufnehmers, gebildet sein. Der Oberflächenwellenresonator 300 umfasst einen Chipkörper 310, welcher in diesem Beispiel eine quadratische Grundform aufweist, welche durch vier Ecken 311 und vier Seitenkanten 314 definiert ist. In oder auf einer Oberseite 313 des Chipkörpers 310 ist eine Resonatorstruktur 320 angeordnet, welche in dieser sowie in den folgenden Figuren nur schematisch, stark vereinfacht dargestellt ist. Die Glasschicht 400 weist einen umlaufenden Außenrand 410 auf, welcher einen Oberflächenabschnitt des Trägersubstrats 200 umschließt, der vollständig von der Glasschicht 400 bedeckt ist. Dabei weist die Glasschicht 400 eine in den Figuren 4A bis 4D näher dargestellte Basisform 413 auf, welche einer ebenfalls in den Figuren 4A bis 4D näher dargestellten Grundform 316 des Chipkörpers 310 entspricht, jedoch größer skaliert ist, sodass sie die Grundform 316 des Chipkörpers 310 vollumfänglich überlappt bzw. umrahmt. Außerdem weist der Außenrand 410 im Bereich einer jeden Ecke 311 des Chipkörpers 310 eine Ausbuchtung 416 auf. Der Chipkörper 310 ist konzentrisch und symmetrisch auf bzw. in der Glasschicht 400 platziert. Dadurch ergibt sich, dass der Außenrand 410 in Bereichen entlang der Seitenkanten 314 zumindest abschnittsweise höchstens um eine erste Länge L1 von der jeweils nächstgelegenen Seitenkante 314 beabstandet ist. Gleichzeitig ist der Außenrand 410 im Bereich der Ausbuchtungen 416 zumindest abschnittsweise mindestens um eine zweite Länge L2 von einer jeweils nächstgelegenen Ecke 311 des Chipkörpers 310 beabstandet. Die zweite Länge L2 ist dabei mindestens um 10% größer als die erste Länge L1.

Figur 2 zeigt eine exemplarische Ausführung eines Oberflächenwellenresonators 300, entsprechend jener aus Figur 1. Der Chipkörper 310 weist eine quadratische Grundform 316 auf und der Chipkörper 310 hat eine Höhe H, welche auch als Dicke des Chipkörpers 310 bezeichnet werden kann.

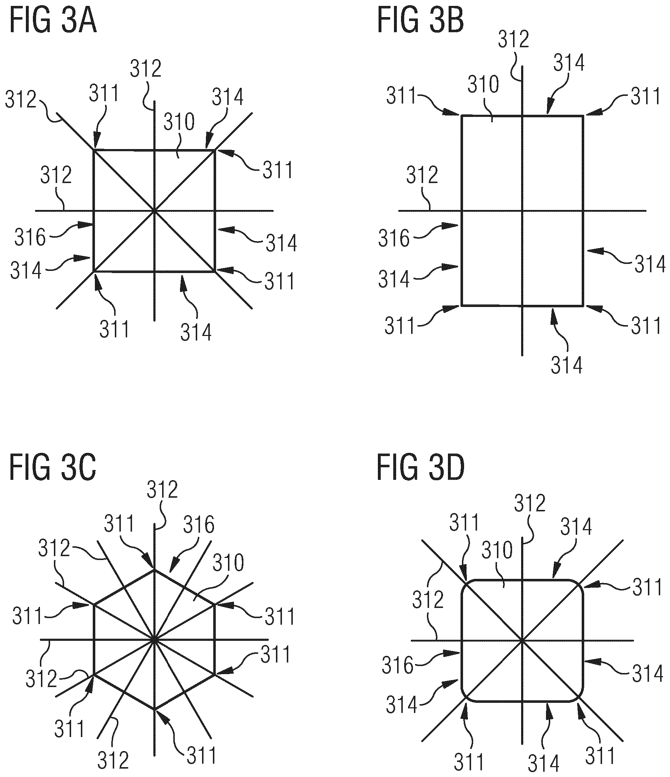

Die Figuren 3A, 3B, 3C und 3D zeigen verschiedene exemplarische Ausführungen des Chipkörpers 310, welche sich jeweils in ihrer Grundform 316 unterscheiden. Zudem sind Symmetrieachsen 312 der verschiedenen Grundformen 316 eingezeichnet. Auf eine Darstellung der Resonatorstruktur 320 wurde in diesen Darstellungen verzichtet, jedoch ist diese jeweils derart ausgerichtet, dass eine Wellenfeldrichtung der Resonatorstruktur 320 parallel zu einer der Symmetrieachsen 312 ausgerichtet ist und die Resonatorstruktur 320 jeweils zum Schnittpunkt der Symmetrieachsen 312 zentriert ist.

Der Chipkörper 310 in Figur 3A weist eine quadratische Grundform 316 auf und ähnelt somit den Ausführungen aus den Figuren 1 und 2. Der Chipkörper 310 in Figur 3B weist hingegen eine rechteckige Grundform 316 auf und dadurch eine geringere Anzahl an Symmetrieachsen 312. In Figur 3C ist ein Chipkörper 310 dargestellt, welcher eine sechseckige Grundform 316 aufweist, wobei alle Seitenkanten 314 in diesem Beispiel gleich lang sind. Der in Figur 3D dargestellte Chipkörper 310 ähnelt in seiner Grundform 316 jenem aus Figur 3A, jedoch sind die Ecken 311 abgerundet geformt. Jede der verschiedenen Grundformen 316 ist definiert durch eine gerade Anzahl von mindestens vier Ecken 311 und ebenso vielen, zwischen jeweils zwei benachbarten Ecken 311 angeordneten Seitenkanten 314. In Figur 3C wurde zugunsten der Übersichtlichkeit auf die Bezugszeichen der Seitenkanten 314 verzichtet.

In den Figuren 4A, 4B, 4C und 4D sind die exemplarischen Chipkörper 310 aus den entsprechenden Figuren 3A, 3B, 3C und 3D als Teil exemplarischer Ausführungen einer Sensorvorrichtung 100 in einer Draufsicht dargestellt. Dazu sind sie jeweils positioniert in einer Glasschicht 400. Die Glasschichten 400 weisen jeweils eine Basisform 413 mit Symmetrieachsen 415 auf, welche der Grundform 316 des jeweils zugeordneten Chipkörpers 310 in Form und Ausrichtung entspricht, jedoch größer ist, sodass ein Außenrand 410 der Glasschicht 400 zwischen der Oberseite 313 und der Unterseite des Chipkörpers 310 verlaufende Randflächen des Chipkörpers 310 zu allen Seiten umrahmt. Die Chipkörper 310 sind jeweils konzentrisch und symmetrisch innerhalb der Glasschichten 400 platziert, sodass der Außenrand 410 der Glasschicht 400 vom Chipkörper 310 jeweils in punktsymmetrischer Weise umlaufend beabstandet ist (im Rahmen technisch möglicher Fertigungsgenauigkeit). Dabei überragt die Basisform 413 die Grundform 316 zu allen Seiten jeweils wenigstens um einen Mindestabstand M. Zusätzlich weisen die Glasschichten 400 im Bereich aller Ecken 311 der jeweiligen Grundform 316 - und somit im Bereich aller Ecken 414 der Basisform - Ausbuchtungen 416 auf. Entlang der Seitenkanten 314 des Chipkörpers 310 (in den Figuren 4A, 4B, 4C und 4D zugunsten der Übersichtlichkeit nicht mit Bezugszeichen versehen) ist der Außenrand 410 abschnittsweise höchstens um einen Abstand L1 vom Chipkörper 310 beabstandet. Im Bereich der Ausbuchtungen 416 ist der Außenrand 410 wiederum abschnittsweise mindestens um eine zweite Länge L2 von der jeweiligen nächstgelegenen Ecke 311 (in den Figuren 4A, 4B, 4C und 4D zugunsten der Übersichtlichkeit nicht mit Bezugszeichen versehen) beabstandet.

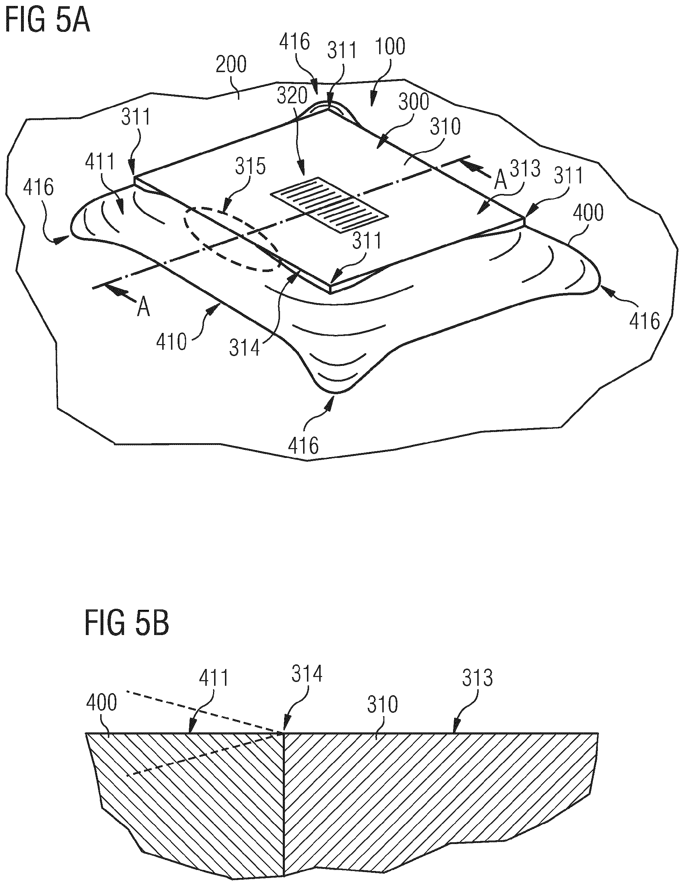

Figur 5A zeigt eine weitere exemplarische Ausführung der Sensorvorrichtung 100 in einer perspektivischen Ansicht. Der Chipkörper 310 ist teilweise eingesunken in der Glasschicht 400 platziert. Dabei schließt sich eine Oberfläche 411 der Glasschicht 400 entlang eines Randabschnitts 315 bündig an die Oberseite 313 des Chipkörpers 310 an.

In Figur 5B ist der Randabschnitt 315 aus Figur 5A in einer Querschnittsdarstellung durch Ebene A, wie in Figur 5A eingezeichnet, dargestellt. Die Oberfläche 411 der Glasschicht 400 schließt sich bündig an die Oberseite 313, also die Oberfläche des Chipkörpers 310, an dessen Seitenkante 314 an. ,Bündig' bedeutet hierbei, dass sich die Glasschicht 400 nicht über die Seitenkante 314 hinweg erstreckt und somit keinen Teil der Oberseite 313 bedeckt, gleichzeitig aber auch keine Stufe zwischen der Oberfläche 411 und der Oberseite 313 verbleibt, wie es etwa exemplarisch an den Ecken 311 in Figur 5A angedeutet ist. Insbesondere schließt sich die Oberfläche 411 der Glasschicht 400 vollumfänglich, entlang aller Ecken 311 und aller Seitenkanten 314, durchgehend bündig an die Oberseite 313 an. In Figur 5B verläuft der Übergang von Oberfläche 411 zu Oberseite 313 stetig, jedoch soll im Sinne dieser Ausführung auch ein leichter Knick in der Steigung, wie in Figur 5B durch gestrichelte Linien angedeutet, ebenso als bündiger Anschluss verstanden werden.

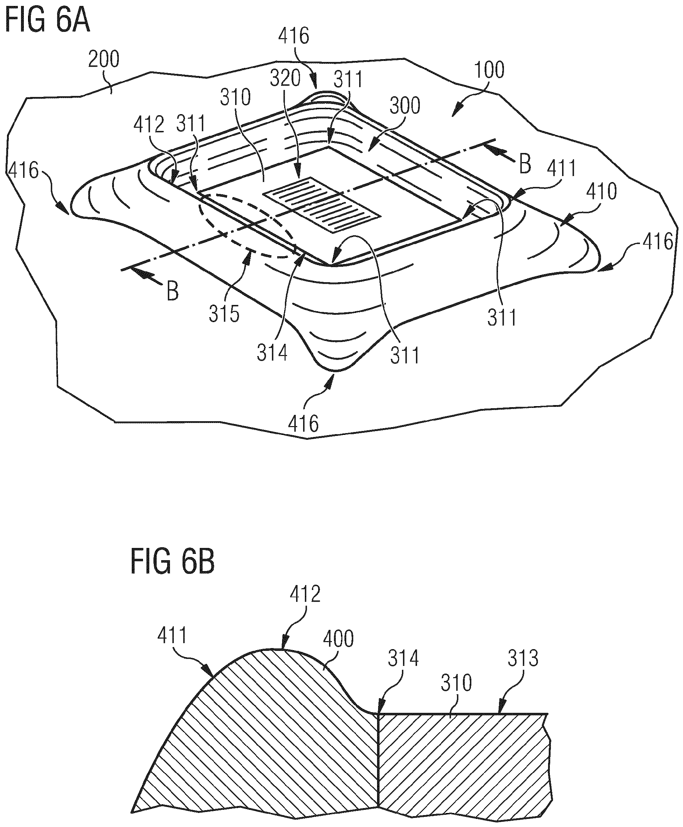

In Figur 6A ist eine weitere exemplarische Ausführung der Sensorvorrichtung 100 in einer perspektivischen Ansicht dargestellt. Die Oberfläche 411 der Glasschicht 400 steigt hierbei in ihrem Verlauf vom Chipkörper 310 weg bis zum ihrem Außenrand 410 hin zunächst zu einem höchsten Punkt 412 an, welcher höher liegt als die Oberseite 313 des Chipkörpers 310. Anschließend fällt sie ohne Ausbildung eines makroskopischen konkav geformten Abschnitts stetig zum Außenrand 410 ab. Dem Vorgenannten soll es nicht entgegenstehen, dass die Glasschicht 400 in Abhängigkeit von ihrer Oberflächenspannung, Viskosität sowie möglicher Mikrostrukturen der Oberfläche des Trägersubstrats 200 direkt am Außenrand 410 auf mikroskopischer Ebene gegebenenfalls einen konvexen Endabschnitt ausbildet. Somit bildet die Glasschicht 400 einen umlaufenden, ringwallartigen Kragen aus, welcher den Oberflächenwellenresonator 300 bzw. den Chipkörper 310 vollumfänglich umrahmt.

In Figur 6B ist abschnittsweise ein Randabschnitt 315 aus Figur 6A in einem Querschnitt durch Ebene B, wie in Figur 6A eingezeichnet, dargestellt. Hierbei wird der Verlauf der Oberfläche 411 vom Seitenrand 314 des Chipkörpers 310 in Richtung des Außenrands 410 ersichtlich. Der höchste Punkt 412 liegt dabei beispielsweise 10-75% der Höhe H des Chipkörper 310 höher als die Oberseite 313 des Chipkörpers 310.

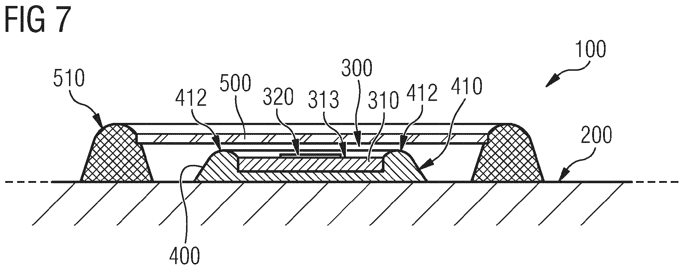

Figur 7 zeigt eine weitere exemplarische Ausführung der Sensorvorrichtung 100 in einem Querschnitt. Die Glasschicht 400 bildet in diesem Beispiel einen umlaufenden Kragen um den Chipkörper 310, wobei der höchste Punkt 412 jeweils höher liegt als die Oberseite 313 des Chipkörpers 310. Weiterhin sind der Oberflächenwellenresonator 300 und die Glasschicht 400 von einem Halterahmen 510 umrahmt, welcher eine Abdeckscheibe 500 trägt. Der Halterahmen 510 ist durch ein Glaslot gebildet und schließt den Oberflächenwellenresonator 300 und die Glasschicht 400 zusammen mit der Abdeckscheibe 500 hermetisch dicht ein. Da die Glasschicht 400 den Kragen mit höchstem Punkt 412 ausbildet, kann die empfindliche Oberseite 313 des Chipkörpers 310 nicht durch die Abdeckscheibe 500 beschädigt werden, selbst wenn diese während des Fertigungsprozesses zu tief in den Halterahmen 510 einsinkt oder verkippt aufgesetzt wird. Die Abdeckscheibe 500 trifft in solchen Fällen dann auf den stabilen, durch die Glasschicht 400 gebildeten Kragen, anstatt auf die Oberseite 313 des Chipkörpers 310.

Der Offenbarungsgehalt dieser Schrift ist nicht auf die Merkmale der vorangehend genannten exemplarischen Ausführungsformen, Ausgestaltungen und/oder Weiterbildungen beschränkt, sondern umfasst auch beliebige Kombinationen dieser Merkmale, insofern sie sich nicht logisch gegenseitig ausschließen. Weiterhin kann sie in dem Umfang der nachfolgenden Ansprüche modifiziert werden. Ebenso können einzelne Aspekte aus den Unteransprüchen miteinander kombiniert werden.

**BEZUGSZEICHENLISTE**

| | |
|---|---|
| 100 | Sensorvorrichtung |
| 200 | Trägersubstrat |
| 300 | Oberflächenwellenresonator |
| 310 | Chipkörper |
| 311 | Ecke der Grundform bzw. des Chipkörpers |
| 312 | Symmetrieachse der Grundform des Chipkörpers |
| 313 | Oberseite des Chipkörpers |
| 314 | Seitenkante der Grundform bzw. des Chipkörpers |
| 315 | Randabschnitt |
| 316 | Grundform des Chipkörpers |
| 320 | Resonatorstruktur |
| 400 | Glasschicht |
| 410 | Außenrand der Glasschicht |
| 411 | Oberfläche der Glasschicht |
| 412 | Höchster Punkt |
| 413 | Basisform der Glasschicht |
| 414 | Ecke der Basisform |
| 415 | Symmetrieachse der Basisform |
| 416 | Ausbuchtung |
| 500 | Abdeckscheibe |
| 510 | Halterahmen |
| A, B | Ebene |
| L1 | Erste Länge |
| L2 | Zweite Länge |
| H | Höhe des Chipkörpers |
| M | Mindestabstand |

## Patentansprüche

1. Sensorvorrichtung (100) umfassend
- ein metallisches Trägersubstrat (200) und
- einen Oberflächenwellenresonator (300) mit
einem Chipkörper (310) und
einer in eine Oberseite (313) des Chipkörpers (310) eingebetteten oder auf der Oberseite (313) aufgetragenen Resonatorstruktur (320),
wobei
der Oberflächenwellenresonator (300) mittels einer Glasschicht (400) auf dem Trägersubstrat (200) befestigt ist.

2. Sensorvorrichtung (100) nach Anspruch 1, wobei die Glasschicht (400) zumindest abschnittsweise zwischen einer der Oberseite (313) gegenüberliegenden Unterseite des Chipkörpers (310) und dem Trägersubstrat (200) angeordnet ist und ein Außenrand (410) der Glasschicht (400) zwischen der Oberseite (313) und der Unterseite des Chipkörpers (310) ausgebildete Randflächen umrahmt.

3. Sensorvorrichtung (100) nach Anspruch 2, wobei
- der Chipkörper (310) eine Grundform (316) aufweist und
- die Glasschicht (400) eine zur Grundform (316) des Chipkörpers (310) symmetrische Basisform (413) aufweist und
- der Chipkörper (310) zentriert und symmetrisch zur Basisform (413) der Glasschicht (400) positioniert ist.

4. Sensorvorrichtung (100) nach Anspruch 3, wobei der Außenrand (410) an jeder Ecke (414) der Basisform (413) jeweils eine nach außen gerichtete Ausbuchtung (416) aufweist.

5. Sensorvorrichtung (100) nach Anspruch 4, wobei der Außenrand (410)
- an wenigstens einer Stelle zwischen zwei aufeinanderfolgenden Ecken (414) der Basisform (413) zumindest abschnittsweise höchstens um eine erste Länge (L1) von einer nächstgelegenen Seitenkante (314) des Chipkörpers (310) beabstandet ist und
- an wenigstens einer der Ausbuchtungen (416) zumindest abschnittsweise mindestens um eine zweite Länge (L2) von einer nächstgelegenen Ecke (311) des Chipkörpers (310) beabstandet ist,
wobei
die zweite Länge (L2) um mindestens 10 % größer ist, insbesondere um mindestens 50 % größer ist, insbesondere um mindestens 100 % größer ist als die erste Länge (L1).

6. Sensorvorrichtung (100) nach Anspruch 5, wobei der Außenrand (410)
- jeweils zwischen jedem Paar von zwei benachbarten Ausbuchtungen (416) an wenigstens einer Stelle zumindest abschnittsweise einen Abstand zur jeweils nächstgelegenen Seitenkante (314) des Chipkörpers (310) aufweist, welcher höchstens der ersten Länge (L1) entspricht, und
- jeweils an jeder Ausbuchtung (416) zumindest abschnittsweise zur jeweiligen nächstgelegenen Ecke (311) des Chipkörpers (310) einen Abstand aufweist, welcher mindestens der zweiten Länge (L2) entspricht.

7. Sensorvorrichtung (100) nach einem der Ansprüche 3 bis 6, wobei die Basisform (413) zu allen Seiten um einen Mindestabstand (M) lateral über die Grundform (316) des Chipkörpers (310) hinausragt, wobei der Mindestabstand (M) das 3-bis 7-fache, insbesondere das 4- bis 6-fache, insbesondere das 5-fache, einer Höhe (H) des Chipkörpers (310) beträgt.

8. Sensorvorrichtung (100) nach einem der Ansprüche 3 bis 7, wobei die
Grundform (316) eine gerade Anzahl von mindestens vier Ecken (311) und mindestens zwei Symmetrieachsen (312) aufweist und
die Basisform (413) eine dementsprechende Anzahl von Ecken (414) und Symmetrieachsen (415) aufweist.

9. Sensorvorrichtung (100) nach Anspruch 2, wobei der Außenrand (410)
- zumindest abschnittsweise in einem Bereich entlang wenigstens einer Seitenkante (314) des Chipkörpers (310) von diesem höchstens um eine erste Länge (L1) beabstandet ist und
- zumindest abschnittsweise in einem Bereich an wenigstens einer Ecke (311) des Chipkörpers (310) von dieser mindestens um eine zweite Länge (L2) beabstandet ist,
wobei
die zweite Länge (L2) um mindestens 10 % größer ist, insbesondere um mindestens 50 % größer ist, insbesondere um mindestens 100 % größer ist, als die erste Länge (L1).

10. Sensorvorrichtung (100) nach Anspruch 9, wobei der Außenrand (410)
- jeweils zumindest abschnittsweise in einem jeweiligen Bereich entlang einer jeden Seitenkante (314) des Chipkörpers (310) von diesem höchstens um die erste Länge (L1) beabstandet ist und
- jeweils zumindest abschnittsweise in einem jeweiligen Bereich an einer jeden Ecke (311) des Chipkörpers (310) von dieser mindestens um die zweite Länge (L2) beabstandet ist.

11. Sensorvorrichtung (100) nach Anspruch 9 oder 10, wobei der Außenrand (410) an jedem Punkt um einen Mindestabstand (M) lateral von einer jeweils nächstgelegenen Seitenkante (314) oder Ecke (311) des Chipkörpers (310) beabstandet ist, wobei der Mindestabstand (M) das 3- bis 7-fache, insbesondere das 4- bis 6-fache, besonders insbesondere das 5-fache, einer Höhe (H) des Chipkörpers (310) beträgt.

12. Sensorvorrichtung (100) nach einem der Ansprüche 9 bis 11, wobei der Chipkörper (310) eine Grundform (316) aufweist, welche durch die Seitenkanten (314) sowie durch eine gerade Anzahl von mindestens vier Ecken (311) gebildet ist,
wobei die Grundform (316) mindestens zwei Symmetrieachsen (312) aufweist.

13. Sensorvorrichtung (100) nach einem der vorangegangenen Ansprüche, wobei sich eine Oberfläche (411) der Glasschicht (400) zumindest entlang eines Randabschnitts (315) des Chipkörpers (310) zumindest im Wesentlichen bündig an die Oberseite (313) anschließt.

14. Sensorvorrichtung (100) nach einem der vorangegangenen Ansprüche, wobei die Oberfläche (411) der Glasschicht (400) zumindest entlang eines Randabschnitts (315) des Chipkörpers (310) in ihrem Verlauf von diesem weg bis zu ihrem Außenrand (410) hin
- zunächst zu einem höchsten Punkt (412) ansteigt, welcher höher liegt als die Oberseite (313) des Chipkörpers (310), und
- anschließend ohne Ausbildung eines makroskopischen konkav geformten Abschnitts stetig zum Außenrand (410) abfällt.

15. Sensorvorrichtung (100) nach Anspruch 14, wobei der höchste Punkt (412) um 10 % bis 75 %, insbesondere um 25 % bis 50 %, einer Höhe (H) des Chipkörpers (310) höher liegt als die Oberseite (313) des Chipkörpers (310).

16. Sensorvorrichtung 100 nach einem der Ansprüche 13 bis 15, wobei der Randabschnitt (315) alle Randflächen des Chipkörpers (310), insbesondere alle Seitenkanten (314) und alle Ecken (311) des Chipkörpers (310), umfasst.

17. Sensorvorrichtung (100) nach einem der Ansprüche 2 bis 16, umfassend
- eine Abdeckscheibe (500) und
- einen Halterahmen (510),
wobei
der Halterahmen (510) den Außenrand (410) umrahmt und die Abdeckscheibe (500) mit dem Trägersubstrat (200) verbindet.

18. Sensorvorrichtung (100) nach Anspruch 17, wobei der Halterahmen (510) aus einem Glaslot gebildet ist, wobei der Halterahmen (510) insbesondere
aus einem anderen Glaslot gebildet ist als die Glasschicht (400) und
dieses andere Glaslot eine niedrigere Schmelztemperatur als das Glaslot, aus dem die Glasschicht (400) gebildet ist, aufweist.

19. Sensorvorrichtung (100) nach einem der vorangegangenen Ansprüche, wobei der Chipkörper (310) aus einem anisotropen Material gebildet ist, welches
in einer ersten Richtung einen ersten Wärmeausdehnungskoeffizienten und eine erste Dehnungssensitivität aufweist, und
in einer zweiten Richtung, welche orthogonal zur ersten Richtung liegt, einen zweiten Wärmeausdehnungskoeffizienten und eine zweite Dehnungssensitivität aufweist,
wobei
der zweite Wärmeausdehnungskoeffizient niedriger als der erste
Wärmeausdehnungskoeffizient ist
und wobei
ein Wärmeausdehnungskoeffizient des Trägersubstrats (200) und/oder ein Wärmeausdehnungskoeffizient der Glasschicht (400) kleiner als der erste Wärmeausdehnungskoeffizient und zugleich größer als der zweite Wärmeausdehnungskoeffizient ist,
die erste Dehnungssensitivität negativ und die zweite Dehnungssensitivität positiv ist und wobei der Chipkörper (310) derart geformt ist, dass
die erste und die zweite Richtung in einer Ebene parallel zur Oberseite (313) des Chipkörpers (310) liegen und
die Resonatorstruktur (320) parallel zur ersten Richtung oder parallel zur zweiten Richtung verläuft.
